# EUROPEAN PATENT SPECIFICATION

(11) **EP 1 700 166 B1**
(45) Date of publication and mention of the grant of the patent: **06.01.2010**
(21) Application number: 04812505.8
(22) Date of filing: 29.11.2004
(51) Int. Cl.: G03F 7/20, B01J 2/14

(54) **METHOD OF FORMING A DEPRESSION IN A SURFACE OF A LAYER OF PHOTORESIST**
VERFAHREN ZUR ERZEUGUNG EINER VERTIEFUNG IN EINER OBERFLÄCHE EINER SCHICHT AUS FOTORESIST
PROCEDE DE FORMATION D'UNE DEPRESSION A LA SURFACE D'UNE COUCHE DE PHOTORESINE

(30) Priority: 12.12.2003 US 734328
(43) Date of publication of application: 13.09.2006
(73) Proprietor: HEWLETT-PACKARD DEVELOPMENT COMPANY, L.P., Houston, TX 77070 (US)
(72) Inventor: SHAARAWI, Mohammed, Corvallis, OR 97330 (US); STRAND, Thomas R., Corvallis, OR 97330-4239 (US)
(74) Representative: Jackson, Richard Eric
(86) International application number: PCT/US2004/040004
(87) International publication number: WO 2005/062129

(56) References cited:
- EP-A- 0 601 887
- EP-A- 1 288 721
- WO-A-94/24610
- US-A- 4 092 166
- US-A- 5 134 058
- US-A- 5 532 090
- US-A- 5 885 749
- US-A- 6 162 589
- US-A1- 2002 090 577
- US-A1- 2002 187 435
- US-B1- 6 238 850
- US-B1- 6 257 370
- US-B1- 6 375 313
- US-B1- 6 528 238
- PATENT ABSTRACTS OF JAPAN vol. 011, no. 370 (P-642), 3 December 1987 (1987-12-03) & JP 62 141548 A (MITSUBISHI ELECTRIC CORP), 25 June 1987 (1987-06-25)

## Description

### BACKGROUND OF THE DISCLOSURE

Photo-resist etching is often used to create micro-structures in micro-electronic devices. For example, photo-resist etching is used to create micro-fluidic chambers, including ink manifolds and firing chambers, in a barrier layer of a fluid ejector such as an ink-jet print head. Photo-resist etching is used to form nozzles or fluid-transfer bores in an orifice layer arranged above the barrier layer of an ink-jet print head.

Counter-bores formed at the exit of a fluid-transfer bore or nozzle can reduce or prevent damage to the exit geometry of a nozzle caused by wiping and can extend the useful life of a fluid ejection device. The counter-bores can reduce or prevent, for example, ruffling of the nozzle exit and reduce or prevent fluid trajectory problems associated with puddling. Counter-bores are formed, for example, by laser ablation, which may increase production costs.

Exemplary methods of forming manifolds, chambers and other features in photo-resistive orifice plates and/or barrier layers are discussed, for example, in US Patents 6,162,589 (Chen et al.) and 6,520,628 (McClelland et al.). Ink jet print heads with nozzle counter-bores formed by laser ablation are described, for example, in commonly assigned U.S. Patent 6,527,370 B1 (Courian et al.).

### BRIEF DESCRIPTION OF THE DRAWINGS

Features and advantages of the invention will be readily appreciated by persons skilled in the art from the following detailed description of exemplary embodiments thereof, as illustrated in the accompanying drawings, in which:

FIG. 1 illustrates a cross-section of an exemplary embodiment of a void in a layer of photo-resist.

FIGS. 2A-2E illustrate cross-sections of an exemplary embodiment of a layer of photo-resist during an exemplary process for forming a void in the layer.

FIGS. 3A-3C illustrate cross-sections of an exemplary embodiment of a layer of photo-resist during an exemplary process for forming a void in the layer.

FIGS. 4A-4D illustrate cross-sections of an exemplary embodiment of a layer of photo-resist during an exemplary process for forming a void in the layer.

FIG. 5A illustrates an exemplary process flow in an exemplary embodiment of a process for forming a void in a layer of photo-resist.

FIG. 5B illustrates an exemplary process flow in an exemplary embodiment of a process for forming a void in a layer of photo-resist.

FIG. 5C illustrates an exemplary process flow in an exemplary embodiment of a process for forming a void in a layer of photo-resist.

FIG. 6A illustrates an exemplary embodiment of a layer of photo-resist disposed on a substrate.

FIG. 6B illustrates an exemplary embodiment of a layer of photo-resist with a void.

FIG. 7A illustrates an exemplary embodiment of a layer of photo-resist disposed on a substrate.

FIG. 7B illustrates an exemplary embodiment of a layer of photo-resist with a void.

### DETAILED DESCRIPTION OF THE DISCLOSURE

In the following detailed description and in the several figures of the drawing, like elements are identified with like reference numerals. The invention is defined in claims 1-9.

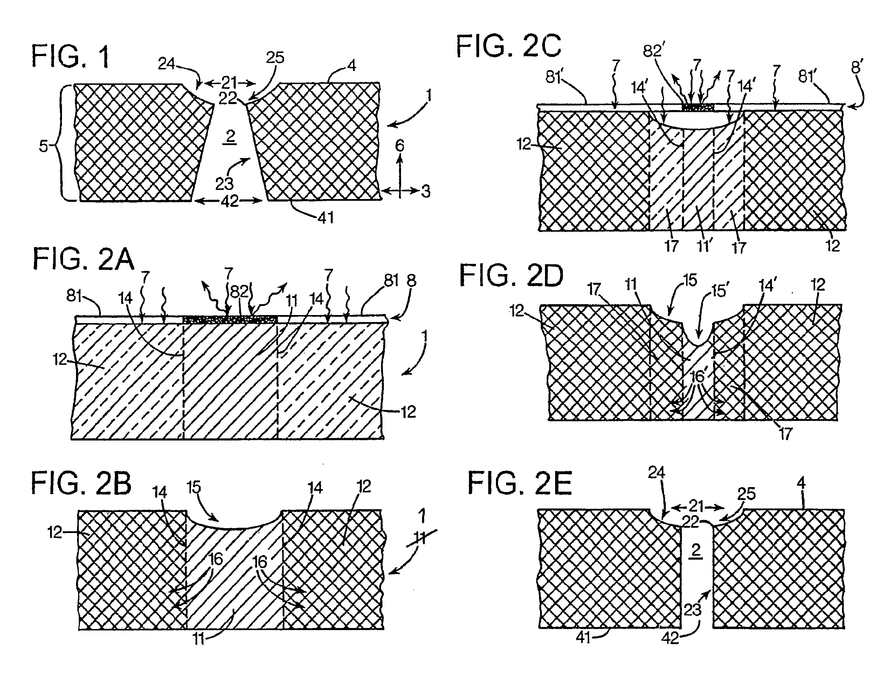

FIG. 1 illustrates an exemplary embodiment of a layer 1 of cross-linked photo-resist with a void 2 formed by an exemplary embodiment of a photo-resist etch process. The layer 1 of photo-resistive film is arranged horizontally in an x-y plane, the direction of which is shown by the arrow 3. The void extends from the upper surface 4 of the layer to a depth 5 along the z-axis 6. The upper surface opening 21 of the void 2 has a cross-sectional area, in a horizontal x-y plane, which is larger than the cross-sectional area in an x-y plane of a medial portion 22 of the void 2. In an exemplary embodiment, a lower portion 23 of the void 2 has a cross-sectional area which may be equal to or greater than the cross-sectional area of the medial portion 22.

In an exemplary embodiment, the layer of photo-resist can comprise a negative-acting photo-resist, such as one sold by Microchem Corporation under the name SU8 (an epoxide photo-resist) or a dry film photo-resist, such as IJ 5000, wh ich is manufactured by DuPont, or other suitable photoresitive film. The photo-resist can comprise any of a number of other negative photoresist materials that become insoluble in developing solutions after exposure to electromagnetic radiation including, for example, SINR-3170M, which is manufactured by Shin Etsu.

In an exemplary embodiment of FIG. 1, the void may have an upper portion 24 which has a cross-sectional area that increases towards the upper surface and narrows toward the medial portion 22 of the void 2. The profile 25 along the slope of the upper portion from the surface may have, for example, a generally parabolic shape (as shown in FIG. 1). Alternatively, the profile 25 can have other shapes, for example, a generally conical shape. The lower portion of the profile has a cross-sectional area that increases toward the bottom or the lower surface.

In an exemplary embodiment of FIG. 1, the layer 1 has an upper surface 4 and a lower surface 41. The void 2 has an upper surface opening 21 and a lower surface opening 42. The void may, for example, form an orifice (or nozzle) in an orifice layer, orifice plate or orifice structure of a fluid emitter. In an exemplary embodiment, the lower surface 41 of the layer 1 can define an upper boundary of a firing chamber in a fluid emitter, one example of which is an ink-jet print-head. The upper portion 21 can comprise a depression or other indentation, which acts as a counter-bore in the orifice.

FIGS. 2A-2E illustrates an exemplary embodiment of a photo-resist etching process for forming a void with a surface depression in a layer of photo-resistive film. The layer can be prepared with a "soft bake" prior to processing, if desirable for a particular photo-resist. For example, a soft bake can be performed after application of a resist coating to remove solvent from the resist by evaporation; after the soft bake, the photo-resist comprises a solvent free thermoplastic. In an exemplary embodiment, the solvent-free thermoplastic comprises SU8 with a glass transition temperature of approximately 55°C. Other resists may have different glass transition temperatures. The glass transition temperature is the temperature at which polymer transforms from a solid to a viscous liquid. The glass transition temperature may also be defined by the temperature at which the slope of the specific volume increases in a plot of specific volume versus temperature for the photo-resistive material.

Referring now to FIG. 2A, portions of photo-resist layer 1 that are not covered by mask 8 are exposed to radiant energy 7. The exposure can be performed, for example, using an SVG Micralign Model 760 exposure tool. In an exemplary embodiment, the radiant energy 7 is monochromatic. In other embodiments, the radiant energy can include energy over a spectral range. In an exemplary embodiment, SU8 is photo-reactive over a range of 300-380 nm. Other photoresists can be photo-reactive over other ranges of wavelengths. In one exemplary embodiment, the mask 8 has a transmissive portion 81 which is substantially transparent to the radiant energy 7 and a non-transmissive portion 82, which is substantially opaque to the radiant energy 7. In an exemplary implementation, the mask 8 is a glass mask with a chrome reflective portion 82. In an exemplary embodiment, the mask is a projection mask, in which the radiant energy passes through a mask, through optics and is directed onto a wafer. In the case of a projection mask, the mask can be larger than the image of the mask projected onto the wafer. A projection mask can be a full wafer mask, for which the exposure pattern for the entire wafer is drawn on the mask, or a step-and-repeat mask, for which the exposure pattern for a portion of the wafer is drawn on the mask and the image projected through the mask is stepped across the wafer, exposing different portions of the wafer at different times. Any type of mask can be used that is operable with the particular photo-resist selected for a given implementation.

The mask 8 allows radiant energy 7 to pass through the transmissive portions, thereby exposing a portion 12 of the layer while leaving an unexposed portion 11. The shape of the unexposed portion 11 of the photo-resist layer 1 is defined by the shape of the non-transmissive portion 82 of the mask where the radiant energy is blocked from reaching the layer. In the exemplary embodiment depicted in FIGS. 2A-2E, the non-transmissive portion 82 has a substantially circular shape and a diameter in a range from about 20 um up to about 40 um. In this embodiment, the outline of the mask 8 in the x-y plane defines the shape, in the x-y plane, of the surface opening 21 (FIG. 2E) of the void 2 to be formed. For example, where a non-circular feature is defined by the mask, then the shape of the counter-bore has that non-circular shape.

In an exemplary embodiment, the exposed portion 12 may receive a relatively low dose of radiant energy 7, for example, about 100 mJoules/cm², or within a range of about 75-300 mJoules/cm² in an embodiment using SU8. The layer may be exposed using a lithographic exposure tool. In a particular application or embodiment, the dose depends, in part, on the tool being used and/or the wavelength of the radiant energy, the photoresist being used, the efficiency of the phoactive element in the resist, the desired shape, depth and other features of the counter-bore and bore to be formed. The desired conditions and parameters can be determined empirically based upon the above described parameters. In an exemplary embodiment, the desirable conditions and parameters are chosen to result in a well-formed round counter-bore that allows for a modulation of depth by changing temperature of subsequent PEB bakes only. For example, in the case of a layer of SU8 with a thickness in a range of about 8-30 um and exposures of about 100mJ/cm², a PEB from about 85-120 deg. C results in counter-bore depths of between 0.2 um and 3um. In this exemplary embodiment, the photo-acid is believed to be generated in the exposed portions 12 whereas no photo-acid is formed in the unexposed portions 11. The amount of photo-acid generated is generally proportional to the exposure dose. The exposed portions 12 meet the unexposed portions 11 at an interface 14 in this exemplary embodiment.

In FIG. 2B, the exposed photo-resist layer 1 of FIG. 2A has been subjected to a post-exposure bake (PEB), during which cross-linking occurs in the exposed portion 12. A PEB can be performed, for example, using an SVG Series 86 bake track. During the PEB, there may be a transition period after cross-linking commences. During the transition period, it is believed that the cross-linking matrix in the exposed portions 12 transforms from a viscous liquid, to a gel, and finally forms a cross-linked three dimensional molecular network. In an exemplary embodiment, a PEB can last for as long as about 5 minutes. It is believed, however, that many of the structural changes and the onset of cross-linking typically occur during the first several seconds of the bake. During this transitional period, the interface 14 becomes an interface between two different materials where the thermodynamic conditions for mixing are met. The thermodynamic conditions for mixing are met where the materials in region 11 and 12 are soluble in each other. The thermodynamic conditions are generally met where the PEB temperature is sufficiently high to permit diffusion of one or both of the materials across the interface 14. This is a balancing act between the temperature of the PEB and counter-bore exposure dose. Where the dose is too low, there may not be sufficient photo-acid produced in the polymer. This can result in little or very slow cross-linking in the exposed areas which in turn may result in an insignificant concentration gradient at the exposure interface which results in little or no diffusion across the interface. If the dose is too high, for example greater than 500 mJ, cross-linking can occur so quickly in a 90 deg. C. PEB that no counter-bore is formed.

In an exemplary embodiment, a depression 15 forms in the surface of the photo-resist during a PEB. It is believed that this occurs, at least in part, due to diffusion 16 across the interface 14 from the unexposed portion 11 into the exposed portion 12. Diffusion can also result in a slight swelling in the surface of the layer in the region of the interface.

In an exemplary embodiment, PEB temperatures are selected to create a relatively high diffusivity which decreases over time as the cross-link density increases during the PEB. The PEB temperatures at which sufficiently high diffusivity exists can be greater than the glass transition temperature, for example in a range of about 80 to 120 deg. C. As monomer is consumed by the cross-linking reaction, a concentration gradient is created at the exposure interface 14 (relatively large groups of assembled monomer versus small groups or single units of monomer) setting up the thermodynamic condition required for diffusion. The temperature can also be selected so that the monomer has sufficient energy to diffuse in the polymer matrix.

In an exemplary embodiment, suitable PEB temperatures are above the glass transition temperature and/or above the melting point of the photo-resist resin. The liquid polymer has relatively high diffusivity. As the photo-resist is heated, monomer is free to cross the exposure boundary in either direction. As time progresses during the PEB, the cross-linking reaction gels the exposed regions, making transport from exposed to unexposed areas more difficult. Transport of monomer from unexposed to exposed regions results in a net transport of monomer into the cross-linking matrix. This unbalanced transport of monomer results in a decrease in volume in unexposed regions.

In an exemplary embodiment, the PEB for an SU8 photo-resist layer is conducted at a temperature within a range of about 80-120 deg. C. The temperatures should be selected to cause sufficient diffusivity at the interface 14 during the cross-linking transition period. Temperatures in the low end of a suitable range of temperatures may result in a depression with a shallower profile, whereas temperatures in the high end of a suitable range may result in a counter-bore with a deeper profile. In an exemplary embodiment, depressions as deep as about 3 microns a re formed. The depth of the depression can be modulated by controlling or varyi ng exposure dose, shape of the mask and bake temperature. As time progresses during the PEB, the crosslink density in exposed regions increases to a point where transport of the monomer is limited by steric hindrance and no further shape change can occur. In exemplary embodiments, a radially symmetric exposure boundary can create generally parabolic or conical depressions 15. I n one exemplary embodiment, a more conical counter-bore results from higher PEB temperatures, for example 100-120 deg. C for SU8. In another exemplary embodiment, a more parabolic counter-bore results from lower PEB temperatures, for example 80-100 deg. C for SU8. In exemplary embodiments with exposure doses lower than about 100 mJ/cm², counter-bore shapes formed in SU8 can be distorted. It is believed that the counter-bore shapes are distorted at low exposure doses because the concentration gradient of crosslinked material across the interface is not well defined, resulting in less net diffusion of material from the non-cross-linked side toward the cross-linking side of the transition. Distortion is also believed to be caused where the light in a low exposure dose is extinguished in the orifice layer resulting in insufficient exposure at the deeper end of the orifice.

In FIG. 2C, the photo-resist layer is exposed to radiant energy through a second mask 8'. In this exemplary embodiment, the non-transmissive portion 82' is smaller than the non-transmissive portion 82 of the first mask 8 (FIG. 2A). In an exemplary embodiment, the mask 8' is arranged to expose portions of the layer that were unexposed in a prior exposure while other portions which were unexposed in a prior exposure remain unexposed. Those portions of the layer which were unexposed during a first exposure and which are exposed during a second exposure comprise a partially exposed portion 17. Those portions that are unexposed during a prior exposure and remain unexposed during this exposure comprise an unexposed portion 11'. The outline of the mask 8' in the x-y plane defines the shape of the narrowest portion of the medial portion of the void. In an exemplary embodiment, the medial portion can have a diameter of about 15 um. In this exemplary embodiment, the second mask 8' is arranged such that, in the x-y plane, the unexposed portion 11' is encompassed by or enclosed within the partially exposed portion 17.

In an exemplary embodiment, the exposure may subject the partially exposed portions 17 to a dose which is higher than the dose received by the exposed portions 12 in a prior exposure. In exemplary embodiments, the partially exposed portions receive a dose in a range of about 600-2000mJoules/cm², for example about 1000 mJoules/cm². In an exemplary embodiment, the dose used to define the unexposed portion 11' is relatively higher than exposure energies in the first exposure of the portions 12, in order to limit diffusion of monomer from the unexposed portion 11' to the partially exposed portion 17 across the transition 14' during a subsequent PEB. This is believed to reduce distortion of the depression by providing for quicker cross-linking in the partially exposed portions, resulting in less diffusion from the unexposed portions to the partially exposed portions across the interface 14'. The total dose received by the exposed portions 12 during both exposures is greater than the total dose received by the partially exposed portions 17.

In FIG. 2D, the exposed photo-resist layer has been subjected to a PEB. In an exemplary embodiment, the temperature of the PEB is in a range of about 80-120 deg. C., for example about 90 deg. C. Using too low of a temperature may increase the variability in the final product. Using too high of a temperature may generate undesirable stresses in the photo-resist. However, the particular temperatures used in a particular embodiment can depend on the materials being used, the structures being formed and the applications for which the products are to be used. Cross-linking occurs in the partially exposed portion 17 during the PEB. Diffusion 16' is also believed to occur across the transition 14' causing a depression 15' at the upper surface of the unexposed portion 11. In an exemplary embodiment, the cross-linked material in the partially exposed portion 17 along the transition 14' defines interior walls of the lower portion of the void to be formed.

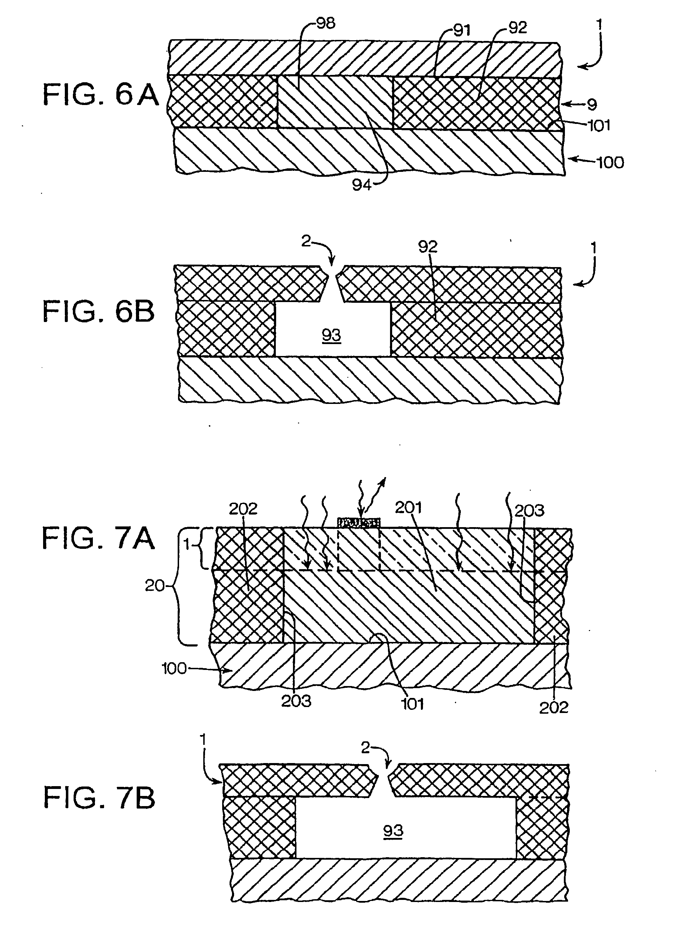

In FIG. 2E, the layer 1 has been developed, for example using a solvent. In an exemplary embodiment, the solvent comprises at least one of ethyl lactate, diacetone alcohol or n-methyl-2-pyrrolidone or other solvent suitable for the particular photo-resist being used. The solvent removes the unexposed portions 11' (shown in FIG. 2C), leaving a void 2 in the photo-resist layer 1. The void 2 comprises a lower portion 23, a medial portion 22 and an upper portion 24. In FIG. 2E and other figures herein, the lower portion is shown with parallel sides by way of example only. It is understood that in exemplary embodiments, the lower portion may widen toward the bottom or toward the lower surface. In an exemplary embodiment, the layer 1 is disposed on top of a layer of other material during processing. In an exemplary embodiment, the layer of other material is positioned in spaces in the barrier layer of a fluid emitter, for example material 94 filling the space whe re a firing chamber of a fluid emitter is to be formed (FIG. 6A). The material 94 is soluble in a solvent and can be removed during development (FIG. 6B).

It is appreciated by those of skill in the art that, in this and other embodiments, the dose absorbed by a portion of photo-resist may be the effective dose, namely radiant energy sufficient to generate sufficient photo-acid to create the conditions for forming the structures described herein. The effective dose may not be the total dose of energy incident on the photo-resist based on the intensity of the radiant energy. For example, where a photo-resist is more reactive to light in certain wavelength range and less reactive to light in another wavelength range, the effective dose can be determined by the distribution of radiation intensities throughout the range of wavelengths that generates photo-acid. For a given amount of radiant energy, a distribution that is weighted with more energy in wavelengths which generate greater amounts of photo-acid will provide a greater effective dose than a distribution which is weighted less heavily with photo-acid generating wavelengths. The dose, or effective dose, sufficient to generate sufficient photo-acid to create the desired void-forming conditions can be provided by any wavelength distribution that generates the desired amount of photo-acid. Increasing the dose may mean increasing the intensity of photo-acid generating wavelengths in any of these distributions. A particular wavelength distribution can be achieved by wavelength filtering a particular source of radiation or tuning the output of the source or selecting a different source.

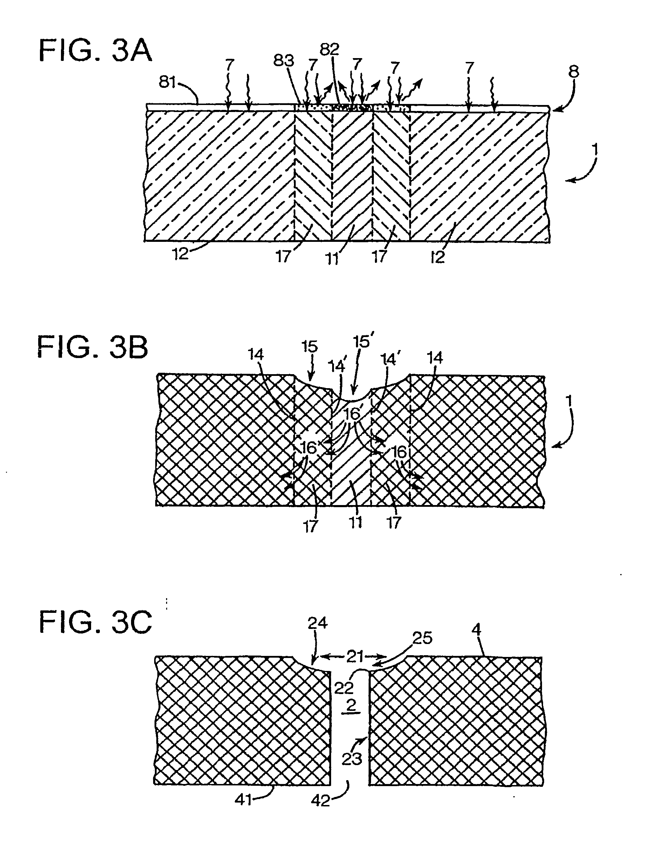

FIGS. 3A-3C illustrate a further exemplary embodiment for forming a void 2 in a layer 1 of photo-resist using an exposure step. In FIG. 3A, the photo-resist layer 1 is exposed to radiant energy 7 through a mask 8. The mask has a transmissive portion 81, a partially transmissive portion 83 and a non-transmissive portion 82. The transmissive portion 81 permits radiant energy 7 to expose an exposed portion 12 of the photo-resist 1. The partially transmissive portion 82 is partially transparent to the radiant energy, permitting some radiant energy to pass while blocking some radiant energy. The partially transmissive portion 82 permits some radiant energy to partially expose a partially exposed portion 17 of the photo-resist 1. The partially exposed portion 17 receives a lower dose than the dose received by the exposed portions 12 received through the transmissive portion 81. The non-transmissive portion 82 blocks radiant energy, leaving an unexposed portion 11 of the photo-resist 1. In an exemplary embodiment using SU8, the transmissivity of the partitially transmissive portion 82 is in a range from 5% to 50%. In an exemplary embodiment, the transmissive portion 81 permits radiant energy of a specific wavelength or range of wavelengths to pass. The photo-resist can be selected such that the photo-resist in the first portion will receive a dose sufficient to generate sufficient photo-acid to form the void described herein. The partially transmissive portion permits radiant energy of a different specific wavelength or range of wavelengths to pass. The photo-resist can be selected such that the photo-resist in the second portion will receive a dose sufficient to generate sufficient photo-acid to form the void described herein.

In FIG. 3B, the exposed photo-resist of FIG. 3A has been subjected to a PEB. In an exemplary embodiment using SU8 photo-resist, the PEB is conducted in a range from 80-120 deg. C and lasts for up to about 5 minutes. During the PEB, diffusion 16 is believed to occur across an interface 14 between the partially exposed portion 17 and the fully exposed portion 12 and diffusion 16' is believed to occur across an interface 14' between the partially exposed portion 17 and the unexposed portion 11. The diffusion is believed to cause the depression 15 to form in the partially exposed portion 17 and to cause a depression 15' to form in the unexposed portion. In an exemplary embodiment, the process parameters can be selected to minimize the amount of diffusion 16' while maximizing the amount of diffusion 16.

In the exemplary embodiment of FIG. 3C, the photo-resist layer 1 has been developed, thereby removing any remaining material from the unexposed portion. The resultant void 2 comprises a lower portion 23, a medial portion 22 and an upper portion 24. The void 2 extends from an upper surface opening 21 at the upper surface 4 to a lower surface opening 42 at the lower surface 41. In an exemplary embodiment, the thickness of the layer 1 is within a range of about 8-30 um. The thickness could also be thinner or thicker.

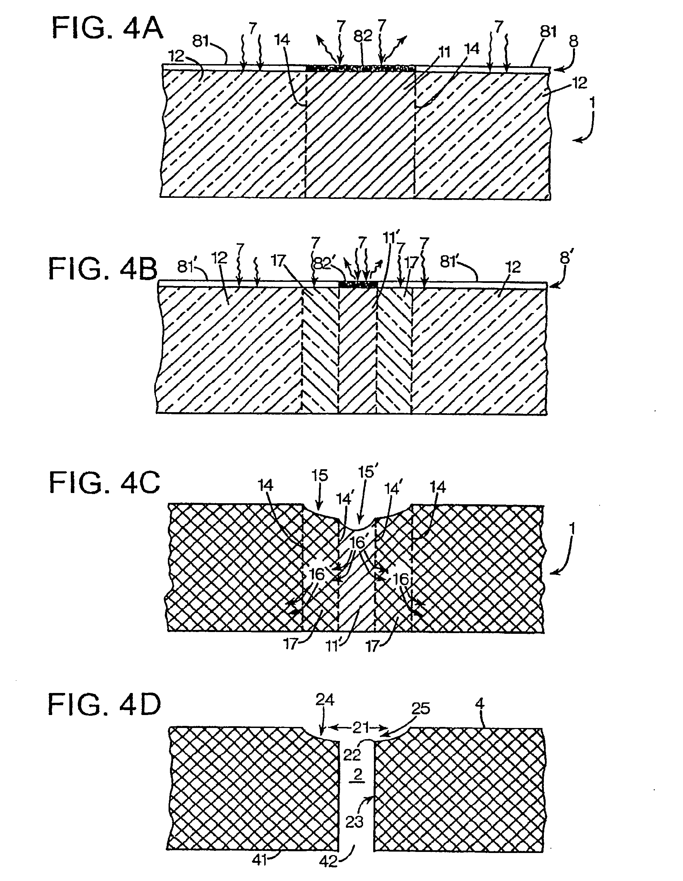

In a further exemplary embodiment, illustrated in FIGS. 4A-4D, a void with a surface depression is formed in a photo-resist layer without performing a PEB after a first exposure. In FIG. 4A, a photo-resist layer is exposed to radiant energy through a mask 8. The mask has a non-transmissive portion 82 and a transmissive portion 81. The transmissive portion permits radiant energy to pass, thereby exposing the exposed portion to radiant energy 7. The non-transmissive portion blocks energy from passing, thereby leaving an unexposed portion 11.

In FIG. 4B, the photo-resist is exposed to radiant energy 7 through a mask 8' with a transmissive portion 81' and a non-transmissive portion 82'. The transmissive portion 81' permits radiant energy to pass, thereby exposing the exposed portion to additional radiant energy and exposing to a partially exposed portion to radiant energy. The non-transmissive portion 82' blocks radiant energy, thereby leaving an unexposed portion 11'. In an exemplary embodiment, the dose is in a range from about 100-2000 mJ/cm². The photo-resist was not subjected to a PEB after the first exposure. In an exemplary embodiment without a PEB between exposures, the mask sequence may be reversed.

In FIG. 4C, the photo-resist has been subjected to a PEB. During the PEB, diffusion 16 occurs across an interface 14 between the partially exposed 17 portion and fully exposed 12 portion and diffusion 16' occurs across an interface 14' between the partially exposed portion 17 and the unexposed portion 11. The diffusion causes a depression 15 to form in the partially exposed portion 17 and a depression 15' to form in the unexposed portion. In an exemplary embodiment, the process parameters can be selected to minimize the amount of diffusion 16' while maximizing the amount of diffusion 16.

In FIG. 4D, the layer has been developed, thereby removing any remaining material from the unexposed portion. The resultant void 2 comprises a lower portion 23, a medial portion 22 and an upper portion 24. The void 2 extends from an upper surface opening 21 at the upper surface 4 to a lower surface opening 42 at the lower su rface 41.

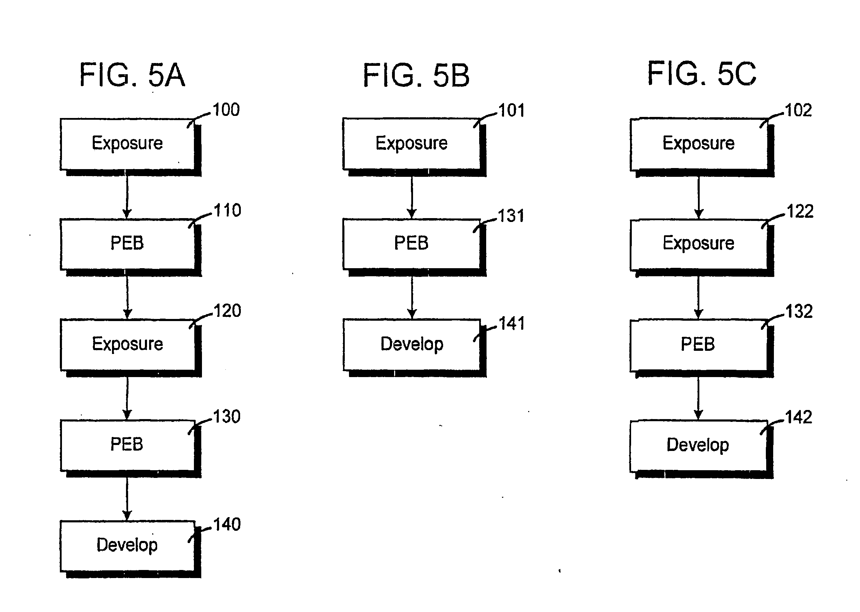

FIGS. 5A, 5B and 5C are process diagrams which illustrate exemplary embodiments of the processes illustrated in FIGS. 2A-E, FIGS. 3A-C and FIGS. 4A-D, respectively. In the exemplary embodiment of 5A, a layer is subjected to a first exposure 100 through a first mask, a first PEB 110, a second exposure 120 through a second mask, a second PEB 130 and is developed 140. In the exemplary embodiment of 5B, a layer of photo-resist is subjected to an exposure 101 through a mask, the mask having a non-transmissive portion and a partially transmissive portion, subjected to a PEB 131and is developed 141. In the exemplary embodiment of FIG. 5C, a layer of photo-resist is subjected to a first exposure 102 through a first mask, a second exposure 122 through a second mask, a PEB 132 and is developed 142.

It is understood that a mask can comprise a plurality of non-transmissive portions and/or partially transmissive portions, corresponding to a plurality of voids and depressions to be formed in a layer of photo-resist. In an exemplary embodiment, the plurality of voids and depressions can correspond to a plurality of and/or an array of bore-holes (or nozzles) with counter-bores in a fluid emitter, such as an ink-jet print head.

FIG. 6A illustrates an exemplary embodiment of a photo-resist layer disposed on a surface 91 of an underlying layer 9 prior to forming any voids. The photo-resist layer can comprise an orifice plate or orifice layer 1 of a fluid emitter, such as an ink-jet print head. The underlying layer 9 can comprise a barrier layer (or chamber layer) 9 of a fluid emitter. The barrier layer 9 may comprise cross-linked photo-resist 92 defining a chamber 93. The chamber 93 or chambers can comprise, for example, a firing chamber, a fluid channel or the like. The chamber 93 may be filled with a filler 94. In an exemplary embodiment, the filler 94 is soluble and is dissolved during development of the photo-resist layer (or orifice layer) 1. In an exemplary embodiment, the filler may comprise photo-resist or photo-resist resin. In an exemplary embodiment, the filler comprises PMGI (polymethylglutarimide), manufactured by Microchem Corporation. The barrier layer 9 is disposed on the surface of a substrate 100. In an exemplary printhead, a thin film layer (not shown) comprising electrical circuitry and heating resistors for a fluid emitter is can be located on the surface 101 of the substrate 100. Those features are omitted here for clarity.

FIG. 6B illustrates the exemplary embodiment of FIG. 6A after a void 2 has been formed by photo-etching in the layer 1. In an exemplary embodiment, the chamber 93 can comprise a firing chamber of a fluid emitter such as an ink-jet printhead.

FIG. 7A illustrates an exemplary embodiment of a photo-resist layer 1 prior to forming a void in the layer 1. The layer 1 is a surface portion of a thicker layer 20 of photo-resist material disposed on the surface 101 of a substrate 100. The layer 1 can defined by the depth to which the thicker layer 20 becomes exposed during the exposure or exposures 100, 101, 102, 120, 122 (FIGS. 5A-C). Below the layer 1, a sub-surface portion 201 remains unexposed, even after the exposure or exposures. The thicker layer 20 may be subjected to preliminary processing (prior to the exposures 100, 101, 102, 120, 122 (FIGS. 5A-C)) to form cross-linked portions 202. The edges 203 of those cross-linked portions may define the walls of a chamber to be formed during development.

FIG. 7B illustrates the exemplary embodiment of FIG. 7A after photo-etching a void 2 in the layer 1. A chamber remains where the unexposed sub-surface portion 201 was removed during development.

The layer 1 may be laminated onto or spun onto the substrate 5. In an exemplary embodiment, the layer may be prepared with a soft bake. In an exemplary embodiment, the soft bake can be in a range of 80-120 deg. C for about 15 minutes.

In an exemplary embodiment, an existing process for making bore-holes without counter-bores can be modified to provide bore holes with counter-bores. The number of steps added to the nozzle-forming process can depend on the particular embodiment employed. The technique is transferable to a variety of existing processes.

In an exemplary embodiment, a process for forming voids without photo-etched surface depressions comprises a patterned exposure, a PEB and a development. This embodiment could be changed by adding an additional exposure (FIG. 5C) or an additional exposure and an additional PEB (FIG. 5A), or by changing the mask used in the exposure (FIG. 5B).

Exemplary embodiments of the processes and methods discussed herein can form counter-bores with a depths in the range from -0.1 to at least 3.5 um deep. Counter-bores with a negative depth (in other words which protrude upward from the surface) may be formed in exemplary embodiments with relatively small counter-bores, for example, with a diameter of about 20 um, where the dose received in the counter-bore region is relatively low, for example in a range of about 100-300 mJ/cm², and where the dose received by the bulk of the resist is relatively high, for example in a range of about 1000 mJ/cm². Control over counter bore depths can be achieved by modulating counter bore diameter, bake temperatures, or both. Counter bore depth is predominantly controlled by the counter bore exposure dose (Exposure 100, 101, 102 (FIGS. 5A-C)) and the subsequent counter-bore PEB (PEB 110, 131, 132 (FIGS. 5A-C)).

It is understood that the above-described embodiments are merely illustrative of the possible specific embodiments which may represent principles of the present invention. Other arrangements may readily be devised in accordance with these principles by those skilled in the art without departing from the scope of the invention.

## Claims

1. A method of forming a depression (15, 15'; 24) in a surface (4) of a layer (1) of photo-resist, the method comprising:
exposing (100, 120; 101; 102, 122) a first portion (12) of the layer (1) of photo-resist with a first dose of radiant energy (7);
exposing (120; 101; 122) a second portion (17) of the layer (1) of photo-resist with a second dose of radiant energy (7), the second dose being greater than the first dose (100, 120); and
baking (110, 130; 131; 132) the layer (1) at an elevated temperature;
the doses of radiant energy (7) and the elevated temperature being selected in dependence on the photo-resist material such that the baking (110, 130; 131; 132) gives rise to the formation of the depression (15, 15' 24) in the surface of the layer (1).

2. The method of Claim 1, wherein the baking (130; 131; 132) of the layer (1) occurs after exposing (120; 101; 122) the second portion (17) of the layer (1) with the second dose of radiant energy.

3. The method of Claim 1, wherein the baking (110) of the layer (1) comprises:
baking (110) the layer after exposing (100) the layer (1) through a first mask (8) and before exposing (120) the layer (1) through a second mask (8'); and
subsequently baking (130) the layer (1) after exposing (120) the layer (1) through the second mask (8').

4. The method of any one of the previous claims, wherein:
the exposing (100, 120; 102, 122) of the first portion (12) of the layer (1) of photo-resist with the first dose of radiation comprises exposing (100; 102) the layer (1) through a first mask (8) having a transmissive portion (81) corresponding to the first portion (12) of the layer (1) and a non-transmissive portion (82) corresponding to the second portion (17) and a third portion (11') of the layer (1); and
exposing (120; 122) the layer (1) through a second mask (8'), the second mask (8') having a transmissive portion (81') corresponding to the first (12) and second (17) portions of the layer (1) and a non-transmissive portion (82') corresponding to the third portion (11') of the layer (1); and
wherein the exposing (120; 122) of the second portion (17) of the layer (1) of photo-resist to the second dose comprises exposing the layer (1) through the second mask (8').

5. The method of claim 3 or claim 4, wherein the exposing (100; 102) of the layer (1) through the first mask (8) comprises exposing the layer (1) with a dose in a range of about 75-300 mJ/cm².

6. The method of any one of claims 3 to 5, wherein the exposing (120; 122) of the layer (1) through the second mask (8') comprises exposing the layer (1) with a dose in a range of about 600-2000 mJ/cm².

7. The method of Claim 1 or Claim 2, further comprising leaving a third portion (11) of the layer (1) unexposed to the radiant energy, wherein:
the exposing (101) of the first portion (12) of the layer (1) to the first dose comprises exposing the layer (1) through a mask (8) having a transmissive portion (81) corresponding to the first portion (12) of the layer (1);
the exposing (101) of the second portion (17) of the layer (1) comprises exposing the layer (1) through the mask (8), the mask (8) also having a partially transmissive portion (83) corresponding to the second portion (17) of the layer (1):
and wherein the leaving of the third portion (11) of the layer (1) of photo-resist unexposed to the radiant energy comprises exposing the layer (1) through the mask (8), the mask (8) also having a non-transmissive portion (82) corresponding to the third portion (11) of the layer (1).

8. The method of any of the previous claims, wherein the baking (110, 130; 131; 132) of the layer (1) is effected at a temperature in a range from 80 to 120 degrees Celsius.

9. The method of any one of the previous claims, further comprising forming an orifice (2) within the depression (15, 15'; 24) in the layer (1).

## Patentansprüche

1. Ein Verfahren zum Bilden einer Vertiefung (15, 15'; 24) in einer Oberfläche (4) einer Schicht (1) aus Photoresist, wobei das Verfahren folgende Schritte umfasst:
Aussetzen (100, 120; 101; 102, 122) eines ersten Abschnitts (12) der Schicht (1) aus Photoresist gegenüber einer ersten Dosis Strahlungsenergie (7);
Aussetzen (120; 101; 122) eines zweiten Abschnitts (17) der Schicht (1) aus Photoresist gegenüber einer zweiten Dosis Strahlungsenergie (7), wobei die zweite Dosis größer ist als die erste Dosis (100, 120); und
Härten (110, 130; 131; 132) der Schicht (1) bei einer erhöhten Temperatur;
wobei die Dosen der Strahlungsenergie (7) und die erhöhte Temperatur abhängig von dem Photoresistmaterial ausgewählt werden, so dass das Härten (110, 130; 131; 132) die Bildung der Vertiefung (15, 15'; 24) in der Oberfläche der Schicht (1) verursacht.

2. Das Verfahren gemäß Anspruch 1, bei dem das Härten (130; 131; 132) der Schicht
(1) nach dem Aussetzen (120; 101; 122) des zweiten Abschnitts (17) der Schicht (1) gegenüber der zweiten Dosis Strahlungsenergie auftritt.

3. Das Verfahren gemäß Anspruch 1, bei dem das Härten (110) der Schicht (1) folgende Schritte umfasst:
Härten (110) der Schicht nach dem Aussetzen (100) der Schicht (1) durch eine erste Maske (8), und vor dem Aussetzen (120) der Schicht (1) durch eine zweite Maske (8'); und
Nachfolgendes Härten (130) der Schicht (1) nach dem Aussetzen (120) der Schicht (1) durch die zweite Maske (8');

4. Das Verfahren gemäß einem der vorhergehenden Ansprüche, bei dem:
das Aussetzen (100, 120; 202, 122) des ersten Abschnitts (12) der Schicht (1) des Photoresists gegenüber der ersten Strahlungsdosis das Aussetzen (100; 102) der Schicht (1) durch eine erste Maske (8) umfasst, die einen durchlässigen Abschnitt (81), der dem ersten Abschnitt (12) der Schicht (1) entspricht, und einen nicht durchlässigen Abschnitt (82), der dem zweiten Abschnitt (17) und einem dritten Abschnitt (11') der Schicht (1) entspricht, aufweist; und
Aussetzen (120; 122) der Schicht (1) durch eine zweite Maske (8'), wobei die zweite Maske (8') einen durchlässigen Abschnitt (81'), der dem ersten (12) und dem zweiten (17) Abschnitt der Schicht (1) entspricht, und einen nicht durchlässigen Abschnitt (82'), der dem dritten Abschnitt (11') der Schicht (1) entspricht, aufweist; und
wobei das Aussetzen (120; 122) des zweiten Abschnitts (17) der Schicht (1) aus Photoresist gegenüber der zweiten Dosis das Aussetzen der Schicht (1) durch die zweite Maske (8') umfasst.

5. Das Verfahren gemäß Anspruch 3 oder Anspruch 4, bei dem das Aussetzen (100; 102) der Schicht (1) durch die erste Maske (8) das Aussetzen der Schicht (1) gegenüber einer Dosis in einem Bereich von etwa 75-300 mJ/cm² umfasst.

6. Das Verfahren gemäß einem der Ansprüche 3 bis 5, bei dem das Aussetzen (120; 122) der Schicht (1) durch die zweite Maske (8') das Aussetzen der Schicht (1) gegenüber einer Dosis in einem Bereich von etwa 600-2000 mJ/cm² umfasst.

7. Das Verfahren gemäß Anspruch 1 oder Anspruch 2, das ferner das Nicht-Ausgesetztlassen eines dritten Abschnitts (11) der Schicht (1) gegenüber der Strahlungsenergie umfasst, wobei:
das Aussetzen (101) des ersten Abschnitts (12) der Schicht (1) gegenüber der ersten Dosis das Aussetzen der Schicht (1) durch eine Maske (8) umfasst, die einen durchlässigen Abschnitt (81) aufweist, der dem ersten Abschnitt (12) der Schicht (1) entspricht,
das Aussetzen (101) des zweiten Abschnitts (17) der Schicht (1) das Aussetzen der Schicht (1) durch die Maske (8) umfasst, wobei die Maske (8) auch einen teilweise durchlässigen Abschnitt (83) aufweist, der dem zweiten Abschnitt (17) der Schicht (1) entspricht;
und wobei das Nicht-Ausgesetztlassen des dritten Abschnitts (11) der Schicht (1) aus Photoresist gegenüber der Strahlungsenergie das Aussetzen der Schicht (1) durch die Maske (8) umfasst, wobei die Maske (8) auch einen nicht durchlässigen Abschnitt (82) aufweist, der dem dritten Abschnitt (11) der Schicht (1) entspricht.

8. Das Verfahren gemäß einem der vorhergehenden Ansprüche, bei dem das Härten (110, 130; 131; 132) der Schicht (1) bei einer Temperatur in einem Bereich von 80 bis 120 Grad Celsius bewirkt wird.

9. Das Verfahren gemäß einem der vorhergehenden Ansprüche, das ferner das Bilden einer Öffnung (2) in der Vertiefung (15, 15'; 24) in der Schicht (1) umfasst.

## Revendications

1. Procédé de formation d'une dépression (15, 15' ; 24) dans une surface (4) d'une couche (1) de résine photosensible, le procédé comprenant les étapes consistant à :
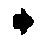 exposer (100, 120 ; 101 ; 102, 122) une première partie (12) de la couche (1) de résine photosensible à une première dose d'énergie rayonnante (7) ;
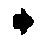 exposer (120 ; 101 ; 122) une deuxième partie (17) de la couche (1) de résine photosensible à une deuxième dose d'énergie rayonnante (7), la deuxième dose étant plus grande que la première dose (100,120);et
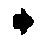 cuire (110, 130 ; 131 ; 132) la couche (1) à une température élevée ;
les doses d'énergie rayonnante (7) et la température élevée étant sélectionnées en fonction du matériau de résine photosensible de telle sorte que la cuisson (110, 130 ; 131 ; 132) provoque la formation de la dépression (15, 15' ; 24) dans la surface de la couche (1).

2. Procédé selon la revendication 1, dans lequel la cuisson (130 ; 131 ; 132) de la couche (1) se produit après l'exposition (120 ; 101 ; 122) de la deuxième partie (17) de la couche (1) à la deuxième dose d'énergie rayonnante.

3. Procédé selon la revendication 1, dans lequel la cuisson (110) de la couche (1) comprend les étapes consistant à :
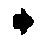 cuire (110) la couche après l'exposition (100) de la couche (1) à travers un premier masque (8) et avant l'exposition (120) de la couche (1) à travers un deuxième masque (8') ; et
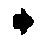 cuire par la suite (130) la couche (1) après l'exposition (120) de la couche (1) à travers le deuxième masque (8').

4. Procédé selon l'une quelconque des revendications précédentes, dans lequel :
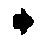 l'exposition (100, 120 ; 102, 122) de la première partie (12) de la couche (1) de résine photosensible avec la première dose de rayonnement comprend l'exposition (100 ; 102) de la couche (1) à travers un premier masque (8) qui présente une partie transmissive (81) qui correspond à la première partie (12) de la couche (1) et une partie non transmissive (82) qui correspond à la deuxième partie (17) et à une troisième partie (11') de la couche (1) ; et
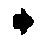 l'exposition (120 ; 122) de la couche (1) à travers un deuxième masque (8'), le deuxième masque (8') présentant une partie transmissive (81') qui correspond à la première (12) et à la deuxième (17) parties de la couche (1) et une partie non transmissive (82') qui correspond à la troisième partie (11') de la couche (1) ; et
dans lequel l'exposition (120 ; 122) de la deuxième partie (17) de la couche (1) de la résine photosensible à la deuxième dose comprend l'exposition de la couche (1) à travers le deuxième masque (8').

5. Procédé selon la revendication 3 ou la revendication 4, dans lequel l'exposition (100 ; 102) de la couche (1) à travers le premier masque (8) comprend l'exposition de la couche (1) à une dose qui se situe dans une plage comprise entre 75 mJ/cm² et 300 mJ/cm² environ.

6. Procédé selon l'une quelconque des revendications 3 à 5, dans lequel l'exposition (120 ; 122) de la couche (1) à travers le deuxième masque (8') comprend l'exposition de la couche (1) à une dose qui se situe dans une plage comprise entre 600 mJ/cm² et 2000 mJ/cm² environ.

7. Procédé selon la revendication 1 ou la revendication 2, comprenant en outre le fait de laisser une troisième partie (11) de la couche (1) non exposée à l'énergie rayonnante, dans lequel :
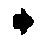 l'exposition (101) de la première partie (12) de la couche (1) à la première dose comprend l'exposition de la couche (1) à travers un masque (8) qui présente une partie transmissive (81) qui correspond à la première partie (12) de la couche (1) ;
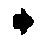 l'exposition (101) de la deuxième partie (17) de la couche (1) comprend l'exposition de la couche (1) à travers le masque, le masque (8) présentant également une partie partiellement transmissive (83) qui correspond à la deuxième partie (17) de la couche (1) ;
et dans lequel le fait de laisser la troisième partie (11) de la couche (1) de résine photosensible non exposée à l'énergie rayonnante, comprend l'exposition de la couche (1) à travers le masque (8), le masque (8) présentant également une partie non transmissive (82) qui correspond à la troisième partie (17) de la couche (1).

8. Procédé selon l'une quelconque des revendications précédentes, dans lequel la cuisson (110, 130 ; 131 ; 132) de la couche (1) est effectuée à une température qui se situe dans une plage comprise entre 80 degrés Celsius et 120 degrés Celsius.

9. Procédé selon l'une quelconque des revendications précédentes, comprenant en outre la formation d'un orifice (2) à l'intérieur de la dépression (15, 15' ; 24) dans la couche (1).
